# EUROPÄISCHE PATENTANMELDUNG

(11) **EP 3 896 853 A1**
(43) Veröffentlichungstag der Anmeldung: **20.10.2021**
(21) Anmeldenummer: 20169867.7
(22) Anmeldetag: 16.04.2020
(51) Int. Cl.: H03K 17/16, H03K 17/0812

(54) **VERFAHREN ZUR ANSTEUERUNG EINES HALBLEITERSCHALTERS**

(71) Anmelder: Siemens Aktiengesellschaft, 80333 München (DE)
(72) Erfinder: Krümmer, Bastian, 96231 Bad Staffelstein (DE); Peller, Stefan, 90542 Eckental (DE); Stadter, Norbert, 96155 Buttenheim (DE)

(57) **Zusammenfassung**

Die Erfindung betrifft ein Verfahren zur Ansteuerung eines, insbesondere abschaltbaren, Halbleiterschalters (T1). Um eine vom Laststrom (IC) im Wesentlichen unabhängige Schaltgeschwindigkeit des Halbleiterschalters (T1) zu erreichen, wird vorgeschlagen, dass ein Ansteuersignal von einer Treiberschaltung (2) erzeugt wird, welche ein Impedanzelement (8) mit einer Induktivität (L, L1, L2) aufweist, wobei das Impedanzelement (8) einen ersten Anschluss (4) und einen zweiten Anschluss (6) aufweist, wobei der erste Anschluss (4) des Impedanzelements (8) mit einem Steueranschluss (10) des Halbleiterschalters (T1) verbunden ist, wobei der zweite Anschluss (6) über einen ersten Schalter (SW1) mit einem Einschaltpotential (Vp) und über einen zweiten Schalter (SW2) mit einem Ausschaltpotential (Vn) verbunden ist, wobei der erste Anschluss (4) über einen dritten Schalter (SW3) mit einem Einschaltpotential (Vp) und über einen vierten Schalter (SW4) mit einem Ausschaltpotential (Vn) verbunden ist, wobei der Steueranschluss (10) durch einen geschlossenen vierten Schalter (SW4) auf das Ausschaltpotential (Vn) geschaltet und der Halbleiterschalter (T1) damit ausgeschaltet wird, während die übrigen Schalter (SW1, SW2, SW3) geöffnet sind, wobei zum Einschalten des Halbleiterschalters (T1) der Steueranschluss (10) durch gleichzeitiges Schließen des ersten Schalters (SW1) und Öffnen des vierten Schalters (SW4) über das Impedanzelement (8) auf das Einschaltpotential (Vp) geschaltet wird, sodass ein Strom (IL) in der Induktivität (L, L1, L2) ansteigt und eine Kapazität des Halbleiterschalters (T1) geladen wird, wobei, sobald eine Steuerspannung (UG) des Halbleiterschalters (T1) das Einschaltpotential (Vp) erreicht, der Steueranschluss (10) durch gleichzeitiges Schließen des dritten Schalters (SW3) und Öffnen des ersten Schalters (SW1) direkt auf das Einschaltpotential (Vp) geschaltet wird.

## Beschreibung

Die Erfindung betrifft ein Verfahren zur Ansteuerung eines, insbesondere abschaltbaren, Halbleiterschalters.

Darüber hinaus betrifft die Erfindung eine Steuereinheit mit Mitteln zur Durchführung eines derartigen Verfahrens.

Ferner betrifft die Erfindung ein Computerprogramm zur Durchführung eines derartigen Verfahrens bei Ablauf in einer Steuereinheit.

Überdies betrifft die Erfindung ein Computerprogrammprodukt mit einem derartigen Computerprogramm.

Des Weiteren betrifft die Erfindung eine Treiberschaltung zur Ansteuerung eines Halbleiterschalters mit einer derartigen Steuereinheit.

Zudem betrifft die Erfindung einen Stromrichter mit zumindest einem Halbleiterschalter und einer derartigen Treiberschaltung.

Eine Treiberschaltung wird zur Ansteuerung eines, insbesondere spannungsgesteuerten und abschaltbaren, Halbleiterschalters verwendet, der beispielsweise in einem Stromrichter eingesetzt wird. Unter einem Stromrichter ist beispielsweise ein Gleichrichter, ein Wechselrichter, ein Umrichter oder ein Gleichspannungswandler zu verstehen. Ein spannungsgesteuerter und abschaltbarer Halbleiterschalter ist beispielsweise als Transistor ausgestaltet, der in einem Schaltbetrieb, vorzugsweise mit einer parallelgeschalteten Inversdiode betrieben wird. Insbesondere ist der Transistor als ein Insulated-Gate-Bipolar-Transistor (IGBT), ein Metalloxide-Semiconductor-Field-Effect-Transistor (MOSFET) oder als ein Feldeffekttransistor, wie ein Sperrschicht-Feldeffekttransistor, ausgeführt. Derartige Schaltelemente zeichnen sich dadurch aus, dass sie einen Steueranschluss aufweisen, der von den weiteren elektrischen Anschlüssen des Schaltelements, insbesondere den Anschlüssen, die an die Schaltstrecke angeschlossen sind, elektrisch isolierend ausgebildet ist. Der Steueranschluss wird häufig auch Gate-Anschluss genannt. Die elektrische Isolation kann durch eine Isolationsschicht, eine in Sperrrichtung mit einer entsprechenden elektrischen Spannung beaufschlagte Sperrschicht oder dergleichen sein.

Bei der Ansteuerung von derartigen Halbleiterschaltern für Schaltanwendungen kommt üblicherweise ein Widerstand am Gate-Anschluss zur Schaltgeschwindigkeitseinstellung zum Einsatz. Eine Treiberendstufe, auch Treiberschaltung genannt, sorgt dabei für die notwendige Ein- bzw. Ausschaltspannung am Gate-Anschluss des Halbleiterschalters. Bei Annahme einer Eingangskapazität des Halbleiterschalters stellt sich ein Gate-Strom ein, der sinnbildlich einer Auf- bzw. Entladekurve einer Kapazität gleicht. Je nachdem wann im Auf- bzw. Entladevorgang der Halbleiterschalter schaltet, stellt sich eine unterschiedliche Kollektor- bzw. Drain-Spannungssteilheit ein. Am Anfang der Auf- bzw. Entladekurve, ändert sich die Kollektor- bzw. Drain-Spannung schnell und am Ende langsam. Daraus resultiert ein schneller Einschaltvorgang bei kleinem Laststrom des Halbleiterschalters, da hier der Schaltvorgang bei niedrigem Millerplateau verhältnismäßig früh eintritt. Bei großem Laststrom des Halbleiterschalters hingegen resultiert ein langsamer Einschaltvorgang, da der Schaltvorgang bei hohem Millerplateau spät eintritt. Analog ergibt sich ein schneller Ausschaltvorgang bei großem Laststrom des Halbleiterschalters, da der Schaltvorgang bei hohem Millerplateau verhältnismäßig früh eintritt, während sich bei kleinem Laststrom des Halbleiterschalters ein langsamer Ausschaltvorgang ergibt, da der Schaltvorgang bei niedrigem Millerplateau verhältnismäßig spät eintritt. Die Folgen aus dieser Eigenschaft sind beim Einschalten hohe Spannungssteilheit bei kleinem Laststrom und hohe Schaltverluste bei großem Laststrom des Halbleiterschalters. Ein schlechtes EMV-Verhalten und eine Abrissneigung von Dioden werden dadurch ebenso begünstigt. Beim Ausschalten ist der Einfluss nicht so ausgeprägt, da der Unterschied des Millerplateaus in Abhängigkeit des zu schaltenden Stromes einen geringeren Einfluss auf eine Höhe des Gate-Stroms hat. Hier setzt der Schaltvorgang im Gegensatz zum Einschalten früh am Anfang der Entladekurve ein. Dennoch führt diese Eigenschaft zu hohen Abschaltüberspannungen bei hohem Strom des Halbleiterschalters.

Die Offenlegungsschrift WO 2011/134092 A2 beschreibt eine Schaltung für einen Multilevel-Umrichter bestehend aus einzelnen Zellen, welche aus einem Zwischenkreiskondensator, sowie für jede Phase aus zwei Halbleiterschaltern, zwei Freilaufdioden und zwei Thyristoren besteht. Die Zwischenkreise der Zellen werden in Serie zusammengeschaltet. Die zu einer Phase gehörenden Thyristoren aller Zellen sind zusammengeschaltet und bilden den Phasenausgang des Umrichters. Bei jeder Phase ist jeweils ein Thyristor eingeschaltet, welcher so die für diese Phase aktive Zelle auswählt. Um das Umschalten der Thyristoren zu ermöglichen, wird eine zusätzliche Spannungsquelle benötigt.

Der Erfindung liegt die Aufgabe zugrunde, ein Verfahren zur Ansteuerung eines, insbesondere abschaltbaren, Halbleiterschalters anzugeben, durch das eine vom Laststrom im Wesentlichen unabhängige Schaltgeschwindigkeit des Halbleiterschalters erreicht wird.

Die Aufgabe wird erfindungsgemäß durch ein Verfahren zur Ansteuerung eines, insbesondere abschaltbaren, Halbleiterschalters gelöst, wobei ein Ansteuersignal von einer Treiberschaltung erzeugt wird, welche ein Impedanzelement mit einer Induktivität aufweist, wobei das Impedanzelement einen ersten Anschluss und einen zweiten Anschluss aufweist, wobei der erste Anschluss des Impedanzelements mit einem Steueranschluss des Halbleiterschalters verbunden ist, wobei der zweite Anschluss über einen ersten Schalter mit einem Einschaltpotential und über einen zweiten Schalter mit einem Ausschaltpotential verbunden ist, wobei der erste Anschluss über einen dritten Schalter mit einem Einschaltpotential und über einen vierten Schalter mit einem Ausschaltpotential verbunden ist, wobei der Steueranschluss durch einen geschlossenen vierten Schalter auf das Ausschaltpotential geschaltet und der Halbleiterschalter damit ausgeschaltet ist, während die übrigen Schalter geöffnet sind, wobei zum Einschalten des Halbleiterschalters der Steueranschluss durch gleichzeitiges Schließen des ersten Schalters und Öffnen des vierten Schalters über das Impedanzelement auf das Einschaltpotential geschaltet wird, sodass ein Strom in der Induktivität ansteigt und eine Kapazität des Halbleiterschalters geladen wird, wobei, sobald eine Steuerspannung des Halbleiterschalters das Einschaltpotential erreicht, der Steueranschluss durch gleichzeitiges Schließen des dritten Schalters und Öffnen des ersten Schalters direkt auf das Einschaltpotential geschaltet wird.

Darüber hinaus wird die Aufgabe erfindungsgemäß durch eine Steuereinheit mit Mitteln zur Durchführung eines derartigen Verfahrens gelöst.

Ferner wird die Aufgabe erfindungsgemäß durch ein Computerprogramm zur Durchführung eines derartigen Verfahrens bei Ablauf in einer Steuereinheit gelöst.

Überdies wird die Aufgabe erfindungsgemäß durch ein Computerprogrammprodukt mit einem derartigen Computerprogramm gelöst.

Des Weiteren wird die Aufgabe erfindungsgemäß durch eine Treiberschaltung zur Ansteuerung eines Halbleiterschalters mit einer derartigen Steuereinheit gelöst.

Zudem wird die Aufgabe erfindungsgemäß durch einen Stromrichter mit zumindest einem, insbesondere abschaltbaren, Halbleiterschalter und einer Treiberschaltung gelöst.

Die in Bezug auf das Verfahren nachstehend angeführten Vorteile und bevorzugten Ausgestaltungen lassen sich sinngemäß auf die Steuereinheit, das Computerprogramm, das Computerprogrammprodukt, die Treiberschaltung und den Stromrichter übertragen.

Der Erfindung liegt die Überlegung zugrunde, einem Halbleiterschalter mittels einer Induktivität einen Steuerstrom, im Falle eines IGBTs einen Gate-Strom, während des Schaltvorgangs zur Verfügung zu stellen, der unabhängig vom zu schaltenden Laststrom des Halbleiterschalters ist. Zu diesem Zweck sind Schalter in einer Treiberschaltung als Steuerschaltelemente nach Art einer Vollbrückenschaltung angeordnet, bei denen jeweils zwei Schalter paarweise in Reihe geschaltet zueinander angeordnet sind. Jede der Reihenschaltungen ist an ein Einschaltpotential, beispielsweise 15 V, und an ein Ausschaltpotential, beispielsweise -8 V, angeschlossen. Die Schalter sind beispielsweise als MOSFETs ausgeführt und werden jeweils von einem Steuersignal angesteuert. Zwischen den durch die Reihenschaltungen ausgebildeten Mittelanschlüssen ist ein Impedanzelement, welches eine Induktivität aufweist, angeschlossen, wobei eine Größe der Induktivität beispielsweise im µH-Bereich liegt. Der Mittelanschluss der Reihenschaltung aus erstem Schalter und zweitem Schalter ist mit einem zweiten Anschluss des Impedanzelements verbunden, während der Mittelanschluss der Reihenschaltung aus drittem Schalter und viertem Schalter mit einem ersten Anschluss des Impedanzelements verbunden ist. Darüber hinaus ist der erste Anschluss am Steueranschluss des Halbleiterschalters angeschlossen, welcher bei einem IGBT dem Gate-Anschluss entspricht.

Vor dem Einschalten ist der Steueranschluss durch einen geschlossenen vierten Schalter auf das Ausschaltpotential geschaltet und der Halbleiterschalter ist damit ausgeschaltet, während die übrigen Schalter geöffnet sind. Zum Einschalten des Halbleiterschalters wird der Steueranschluss durch gleichzeitiges Schließen des ersten Schalters und Öffnen des vierten Schalters über das Impedanzelement auf das Einschaltpotential geschaltet, sodass ein Strom in der Induktivität IL ansteigt und eine Kapazität des Halbleiterschalters geladen wird. Eine zu ladende Kapazität des Halbleiterschalters ist beispielsweise bei einem IGBT eine Gate-Emitter-Kapazität und/oder eine Gate-Kollektor-Kapazität, welche auch Millerkapazität genannt wird. Sobald eine Steuerspannung des Halbleiterschalters, beispielsweise eine Gate-Emitter-Spannung bei einem IGBT, zu einem ersten Zeitpunkt das Einschaltpotential erreicht, wird der Steueranschluss durch gleichzeitiges Schließen des dritten Schalters und Öffnen des ersten Schalters direkt auf das Einschaltpotential geschaltet. Der Strom der Induktivität läuft über den dritten Schalter und einer parallelen Diode des zweiten Schalters frei, womit eine Energie der Induktivität in die Treiberversorgung zurückgewonnen wird. Der dritte Schalter übernimmt mit dem zweiten Schalter neben dem Freilauf der Induktivität zusätzlich die Klemmung des Steueranschlusses. Durch die Induktivität wird dem Halbleiterschalter ein Steuerstrom, insbesondere Gatestrom, während des Schaltvorgangs zur Verfügung gestellt, der unabhängig vom zu schaltenden Laststrom des Halbleiterschalters ist. Dies bedeutet, dass eine Umladung der Millerkapazität des Halbleiterschalters beim Schaltvorgang mit vergleichsweise unverändertem Steuerstrom, insbesondere Gatestrom, erfolgt. Des Weiteren sorgt die Millerkapazität des Halbleiterschalters während des Ein- und Ausschaltens für zusätzliche Energie in der Induktivität, so dass diese zusätzlich die Treiberversorgung speist. Damit kann sich die Treiberschaltung während des Betriebs des Halbleiterschalters selbst versorgen. Darüber hinaus ist der Schaltungsaufwand gegenüber einer konventionellen Konstantstromansteuerung vergleichsweise gering. Darüber hinaus weist der Steuerstrom, insbesondere Gatestrom, gegenüber einer Widerstandssteuerung einen geringeren Spitzenstrom auf, womit kleinere Treibertransistoren verwendbar sind, was eine Integration der Treiberschaltung in ein Halbleitermodul begünstigt. Ferner sorgt die unmittelbar mit dem Steueranschluss verbundene Halbbrücke für eine niederohmige Klemmung des Steueranschlusses gegen das Einschaltpotential oder das Ausschaltpotential, wodurch die Wahrscheinlichkeit von parasitären Einschaltvorgängen, welche beispielsweise zu Kurzschlussströmen führen, minimiert wird.

Ein derartiges Ansteuerverfahren ermöglicht höhere Schaltfrequenzen bei höherer Gate-Ladung und höhere Umgebungstemperaturen, die beispielsweise durch höhere maximale Chiptemperaturen von IGBT-Modulen hervorgerufen werden. Die Ansteuerung sorgt darüber hinaus für EMV-freundliches Verhalten, da ein im Wesentlichen konstanter Steuerstrom, insbesondere Gate-Strom, aufgrund der verwendeten Induktivität beim Umladen der Millerkapazität herrscht. Die Mittel zur Durchführung des Verfahrens umfassen beispielweise einen Mikrocontroller oder einen anderen programmierbaren Logikbaustein und ein Computerprogramm. Die Steuereinheit ist beispielsweise dem Mikrocontroller zugeordnet.

Eine weitere Ausführungsform sieht vor, dass zum Ausschalten des Halbleiterschalters der Steueranschluss durch gleichzeitiges Schließen des zweiten Schalters und Öffnen des dritten Schalters über das Impedanzelement auf das Ausschaltpotential geschaltet wird, sodass der Strom in der Induktivität ansteigt und eine Kapazität des Halbleiterschalters geladen wird, wobei, sobald die Steuerspannung des Halbleiterschalters das Ausschaltpotential erreicht, der Steueranschluss durch gleichzeitiges Schließen des vierten Schalters und Öffnen des dritten Schalters direkt auf das Ausschaltpotential geschaltet wird. Durch die Induktivität wird dem Halbleiterschalter ein Steuerstrom, insbesondere Gatestrom, während des Schaltvorgangs zur Verfügung gestellt, der unabhängig vom zu schaltenden Laststrom des Halbleiterschalters ist. Dies bedeutet, dass eine Umladung der Millerkapazität des Halbleiterschalters beim Schaltvorgang mit vergleichsweise unverändertem Steuerstrom, insbesondere Gatestrom, erfolgt. Des Weiteren sorgt die Millerkapazität des Halbleiterschalters während des Ein- und Ausschaltens für zusätzliche Energie in der Induktivität, sodass diese zusätzlich die Treiberversorgung speist. Damit kann sich die Treiberschaltung während des Betriebs des Halbleiterschalters selbst versorgen.

Besonders vorteilhaft wird ein erster Zeitpunkt, an dem die Steuerspannung des Halbleiterschalters das Einschaltpotential erreicht, detektiert, wobei der Steueranschluss anhand des detektierten ersten Zeitpunks direkt auf das Einschaltpotential geschaltet wird. Mittel zur Detektion des ersten Zeitpunkts umfassen beispielsweise einen Detektor, insbesondere einen Schwellwertschalter wie einen Komparator oder einen Schmitt-Trigger, eine Diode und/oder einen Transistor. Ein derartiges zustandsgesteuertes Schaltverfahren ist vorteilhaft, da eine Zeitdauer bis zum Erreichen des Einschaltpotentials, beispielsweise aufgrund eines harten Kurzschlusses des Halbleiterschalters oder aufgrund von Toleranzen, unterschiedlich sein kann. Eine derartige Detektion des ersten Zeitpunkts erfolgt schnell und präzise.

Eine weitere Ausführungsform sieht vor, dass ein zweiter Zeitpunkt, an dem die Steuerspannung des Halbleiterschalters das Ausschaltpotential erreicht, detektiert wird, wobei der Steueranschluss anhand des detektierten zweiten Zeitpunks direkt auf das Ausschaltpotential geschaltet wird. Mittel zur Detektion des zweiten Zeitpunkts umfassen beispielsweise einen Detektor, insbesondere einen Schwellwertschalter wie einen Komparator oder einen Schmitt Trigger, eine Diode und/oder einen Transistor. Insbesondere ist ein gemeinsamer Detektor für die Detektion des ersten Zeitpunks und des zweiten Zeitpunks verwendbar. Ein derartiges zustandsgesteuertes Schaltverfahren ist vorteilhaft, da eine Zeitdauer bis zum Erreichen des Ausschaltpotentials, beispielsweise aufgrund eines harten Kurzschlusses des Halbleiterschalters oder aufgrund von Toleranzen, unterschiedlich sein kann. Eine derartige Detektion des zweiten Zeitpunkts erfolgt schnell und präzise.

Eine weitere Ausführungsform sieht vor, dass der erste Zeitpunkt und/oder der zweite Zeitpunkt mit Hilfe zumindest einer Vergleichsoperation detektiert werden. Für eine derartige Vergleichsoperation ist beispielsweise ein Schwellwertschalter wie einen Komparator oder einen Schmitt-Trigger verwendbar. Insbesondere wird eine Spannung ausgegeben, wenn ein Schwellwert überschritten wird. Eine derartige Vergleichsoperation ist sehr genau und schaltungstechnisch einfach zu realisieren.

Eine weitere Ausführungsform sieht vor, dass die Spannungsversorgung als unipolare Spannungsversorgung ausgeführt ist, wobei das Ausschaltpotential einem Bezugspotential entspricht. Ein Bezugspotential ist beispielsweise ein Massepotential. Eine derartige Schaltung ist für eine unipolare Spannungsversorgung ist vorteilhaft, da der Steueranschluss, welcher bei einem IGBT dem Gate-Anschluss entspricht, im nichtleitenden Zustand des Halbleiterschalters niederohmig mit einem Emitterpotential oder Sourcepotential, welches mit dem Bezugspotential, insbesondere auf Masse, liegt, verbunden ist. Die Wahrscheinlichkeit eines parasitären Einschaltvorgangs wird somit minimiert.

Eine weitere Ausführungsform sieht vor, dass zumindest zwei der Schalter unabhängig voneinander angesteuert werden. Beispielsweise werden der erste Schalter und der dritte Schalter unabhängig voneinander angesteuert. Da Schaltzeiten, beispielsweise aufgrund von Toleranzen und/oder unterschiedlichen Temperaturen, variieren können, sind durch eine unabhängige Ansteuerung höhere Schaltfrequenzen und geringere Verluste des Halbleiterschalters erreichbar.

Eine weitere Ausführungsform sieht vor, dass die Treiberschaltung für die Ansteuerung eines IGBTs ausgelegt ist, wobei für die Schalter MOSFETS und/oder Bipolartransistoren verwendet werden. Erfahrungsgemäß haben sich derartige Schalter als besonders vorteilhaft erwiesen.

Im Folgenden wird die Erfindung anhand der in den Figuren dargestellten Ausführungsbeispiele näher beschrieben und erläutert.

Es zeigen:
- FIG 1: eine schematische Schaltbilddarstellung einer ersten Ausgestaltung einer Treiberschaltung,
- FIG 2: eine schematische Diagrammdarstellung eines Einschaltvorgangs und eines Ausschaltvorgangs eines Halbleiterschalters,
- FIG 3: eine schematische Schaltbilddarstellung einer zweiten Ausgestaltung einer Treiberschaltung,
- FIG 4: eine schematische Schaltbilddarstellung einer dritten Ausgestaltung einer Treiberschaltung,
- FIG 5: eine schematische Schaltbilddarstellung einer vierten Ausgestaltung einer Treiberschaltung und
- FIG 6: eine schematische Schaltbilddarstellung einer fünften Ausgestaltung einer Treiberschaltung.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

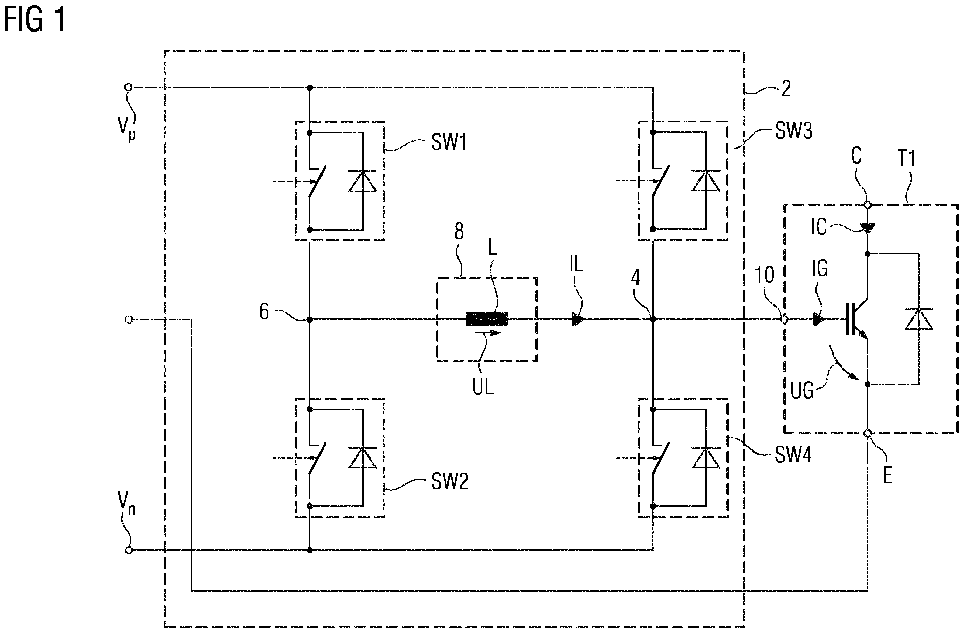

FIG 1 zeigt eine schematische Schaltbilddarstellung einer ersten Ausgestaltung einer Treiberschaltung 2, die es erlaubt, die Schalteigenschaften eines Halbleiterschalters T1, der in FIG 1 exemplarisch als IGBT ausgeführt ist, während des bestimmungsgemäßen Schaltbetriebs an einen aktuellen Arbeitspunkt oder ein gewünschtes Schaltverhalten anpassen zu können. Zu diesem Zweck sind Schalter SW1, SW2, SW3, SW4 als Steuerschaltelemente nach Art einer Vollbrückenschaltung angeordnet, bei denen jeweils zwei Schalter SW1, SW2 sowie SW3, SW4 jeweils paarweise in Reihe geschaltet zueinander angeordnet sind. Jede der Reihenschaltungen ist an ein Einschaltpotential Vp, beispielsweise 15 V, und an ein Ausschaltpotential Vn, beispielsweise -8 V, angeschlossen. Die Schalter SW1, SW2, SW3, SW4 sind beispielsweise als MOSFETs ausgeführt und werden jeweils von einem Steuersignal S1, S2, S3, S4 angesteuert, wobei die Schalter SW1, SW2, SW3, SW4 unabhängig voneinander ansteuerbar sind. Optional ist die Treiberschaltung 2 mit einer unipolaren Spannungsversorgung betreibbar, wobei das Ausschaltpotential Vn einem Bezugspotential entspricht.

Zwischen den durch die Reihenschaltungen ausgebildeten Mittelanschlüssen ist ein Impedanzelement 8, welches eine Induktivität L umfasst, angeschlossen wobei eine Größe der Induktivität beispielsweise im µH-Bereich liegt. Der Mittelanschluss der Schalter SW3, SW4 ist mit einem ersten Anschluss 4 des Impedanzelements 8 verbunden; der Mittelanschluss der Schalter SW1, SW2 ist mit einem zweiten Anschluss 6 des Impedanzelements 8 verbunden. Darüber hinaus ist der erste Anschluss 4 an einem Steueranschluss 10 des Halbleiterschalters T1 angeschlossen, welcher in FIG 1 dem Gate-Anschluss G des IGBTs entspricht.

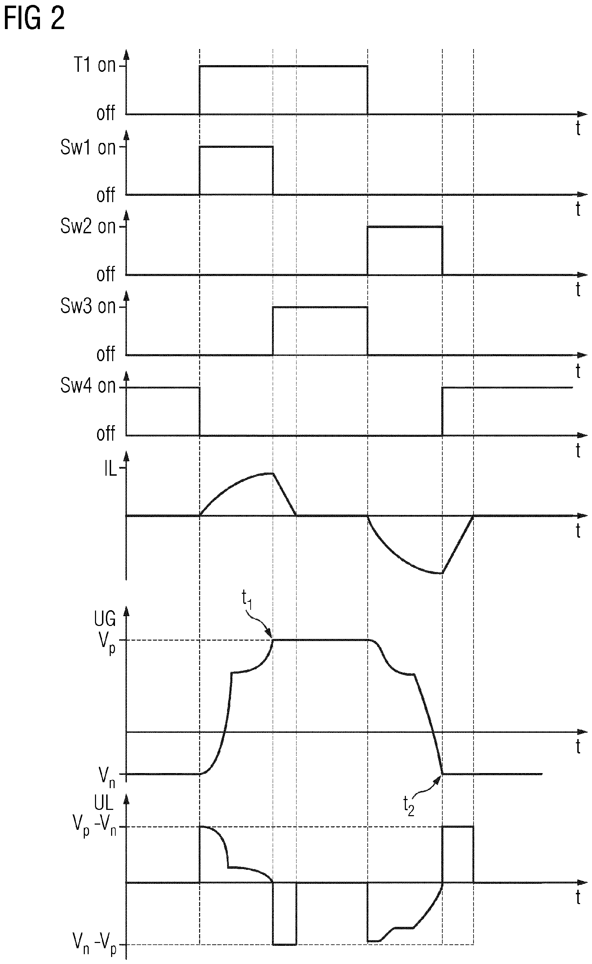

FIG 2 zeigt eine schematische Diagrammdarstellung eines Einschaltvorgangs und eines Ausschaltvorgangs eines Halbleiterschalters T1. Die zugehörige Treiberschaltung 2 ist beispielsweise wie in FIG 1 dargestellt ausgeführt, wobei der Steueranschluss 10 durch einen geschlossenen vierten Schalter SW4 auf das Ausschaltpotential Vn geschaltet und der Halbleiterschalter T1 damit geöffnet beziehungsweise ausgeschaltet ist, während die übrigen Schalter SW1, SW2, SW3 geöffnet sind. Zum Einschalten des Halbleiterschalters T1 wird der Steueranschluss 10 durch gleichzeitiges Schließen des ersten Schalters SW1 und Öffnen des vierten Schalters SW4 über das Impedanzelement 8 auf das Einschaltpotential Vp geschaltet, sodass ein Strom in der Induktivität L ansteigt und eine Kapazität des Halbleiterschalters T1 geladen wird. Eine Kapazität des Halbleiterschalters T1 sind beim in FIG 1 dargestellten IGBT insbesondere die Gate-Emitter-Kapazität und die Gate-Kollektor-Kapazität, welche auch Millerkapazität genannt wird.

Sobald eine Steuerspannung UG des Halbleiterschalters T1, welche beim in FIG 1 dargestellten IGBT der Gate-Emitter-Spannung entspricht, zu einem ersten Zeitpunkt t1 das Einschaltpotential Vp erreicht, wird der Steueranschluss 10 durch gleichzeitiges Schließen des dritten Schalters SW3 und Öffnen des ersten Schalters SW1 direkt auf das Einschaltpotential Vp geschaltet. Der Strom IL durch die Induktivität L läuft über den dritten Schalter SW3 und einer parallelen Diode des zweiten Schalters SW2 frei, womit eine Energie der Induktivität L in die Treiberversorgung zurückgewonnen wird. Der dritte Schalter SW3 übernimmt mit der parallelen Diode des zweiten Schalter SW2 neben dem Freilauf der Induktivität L zusätzlich die Klemmung des Gates G des als IGBT ausgeführten Halbleiterschalters T1, wodurch die Wahrscheinlichkeit von parasitären Einschaltvorgängen, welche beispielsweise bei Kurzschlussströmen auftreten, minimiert wird.

Durch die Induktivität L wird dem Halbleiterschalter T1 ein Gatestrom IG während des Schaltvorgangs zur Verfügung gestellt, der unabhängig vom zu schaltenden Strom IC des Halbleiterschalters T1 ist. Dies bedeutet, dass eine Umladung der Millerkapazität des Halbleiterschalters T1 beim Schaltvorgang mit vergleichsweise unverändertem Gatestrom IG erfolgt. Des Weiteren sorgt die Millerkapazität des Halbleiterschalters T1 während des Ein- und Ausschaltens für zusätzliche Energie in der Induktivität L, so dass diese zusätzlich die Treiberversorgung speist. Damit kann sich die Treiberschaltung 2 während des Betriebs des Halbleiterschalters T1 selbst versorgen. Somit kann eine Treiberversorgung entfallen, wenn bei einem Anlauf und einem Stillstand des Halbleiterschalters T1 eine Anlaufschaltung, welche beispielsweise Widerstände umfasst, für einen Grundlaststrom der Treiberschaltung 2 sorgt.

Zum Ausschalten des Halbleiterschalters T1 wird der Steueranschluss 10 durch gleichzeitiges Schließen des zweiten Schalters SW2 und Öffnen des dritten Schalters SW3 über das Impedanzelement 8 auf das Ausschaltpotential Vn geschaltet, sodass der Strom IL in der Induktivität L in negativer Richtung ansteigt und eine Kapazität des Halbleiterschalters T1 geladen wird. Sobald die Steuerspannung 10 des Halbleiterschalters T1 zu einem zweiten Zeitpunkt t2 das Ausschaltpotential Vn erreicht, wird der Steueranschluss 10 durch gleichzeitiges Schließen des vierten Schalters SW4 und Öffnen des dritten Schalters SW3 direkt auf das Ausschaltpotential Vn geschaltet.

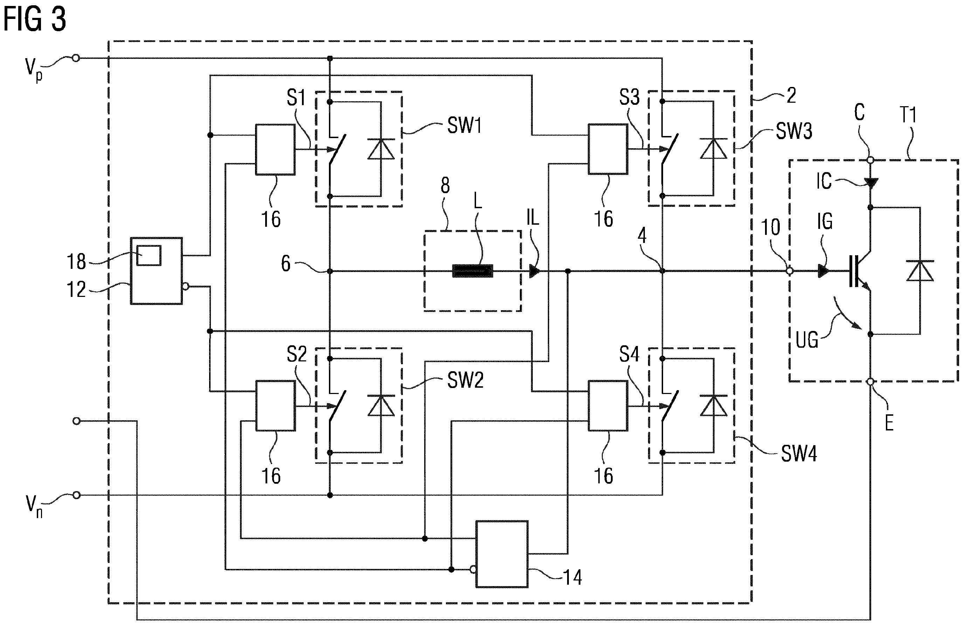

FIG 3 zeigt eine schematische Schaltbilddarstellung einer zweiten Ausgestaltung einer Treiberschaltung 2, wobei die Schalter SW1, SW2, SW3, SW4 der Treiberschaltung 2 von einem Pulsweitenmodulator 12 angesteuert werden. Eine Detektionsvorrichtung 14, welche elektrisch leitend mit dem Steueranschluss 10 verbunden ist, ist dafür ausgeführt, den ersten Zeitpunkt t1, an dem die Steuerspannung UG das Einschaltpotential Vp erreicht, und den zweiten Zeitpunkt t2, an dem die Steuerspannung UG das Ausschaltpotential Vn erreicht, zu detektieren. Beispielsweise ist die Detektionsvorrichtung 14 als Schwellwertschalter, insbesondere als Schmitt-Trigger, oder als Komparator ausgeführt und weist, wie der Pulsweitenmodulator 12, einen nicht-invertierenden und einen invertierenden Ausgang auf. Der nicht-invertierende Ausgang gibt, sobald die Steuerspannung UG einen Schwellwert überschreitet, eine Spannung aus, die einer logischen 1 entspricht. Um die Schalter SW1, SW2, SW3, SW4 wie in FIG 2 dargestellt anzusteuern, werden die Ausgangssignale der Detektionsvorrichtung 14 mit den Ausgangssignalen des Pulsweitenmodulators 12 über jeweils eine logische Schaltung 16 miteinander verknüpft. Die logische Schaltung ist in FIG 3 als UND-Gatter ausgeführt. Die dem ersten Schalter SW1 zugeordnete logische Schaltung 16 ist mit dem nicht-invertierenden Ausgang des Pulsweitenmodulators 12 und mit dem invertierenden Ausgang der Detektionsvorrichtung 14 verbunden, während die dem dritten Schalter SW3 zugeordnete logische Schaltung 16 mit dem nicht-invertierenden Ausgang des Pulsweitenmodulators 12 und mit dem nicht-invertierenden Ausgang der Detektionsvorrichtung 14 verbunden ist.

Beim Einschalten gibt der Pulsweitenmodulator 12 über den nicht-invertierenden Ausgang an die Schalter SW1 und SW3 eine logische 1 aus, während an die Schalter SW2 und SW4 über den invertierenden Ausgang eine logische 0 ausgegeben wird. Solange die Steuerspannung UG das Einschaltpotential Vp nicht erreicht, gibt die Detektionsvorrichtung 14 an die dem dritten Schalter SW3 zugeordnete logische Schaltung 16 eine logische 0 und an die dem ersten Schalter SW1 zugeordnete logische Schaltung 16 eine logische 1 aus, sodass der erste Schalter SW1 geschlossen und der dritte Schalter SW3 offen ist. Die Schalter SW2 und SW4 sind ebenfalls geöffnet, da der invertierende Ausgang des Pulsweitenmodulators 12 an die den Schaltern SW2 und SW4 zugeordneten logischen Schaltungen 16 eine logische 0 ausgibt.

Sobald eine Steuerspannung UG des Halbleiterschalters T1 zu einem ersten Zeitpunkt t1 das Einschaltpotential Vp erreicht, gibt die Detektionsvorrichtung 14 an die dem ersten Schalter SW1 zugeordnete logische Schaltung 16 eine logische 0 und an die dem dritten Schalter SW3 zugeordnete logische Schaltung 16 eine logische 1 aus, sodass der Steueranschluss 10 durch gleichzeitiges Schließen des dritten Schalters SW3 und Öffnen des ersten Schalters SW1 direkt auf das Einschaltpotential Vp geschaltet wird. Der Ausschaltvorgang erfolgt analog. Eine Steuereinheit 18 ist zur Steuerung des Einschaltvorgangs und des Ausschaltvorgangs des Halbleiterschalters T1 vorgesehen. Die Steuereinheit ist optional in einer externen Schaltung angeordnet. Die weitere Ausführung der Treiberschaltung 2 in FIG 3 entspricht der Ausführung in FIG 1.

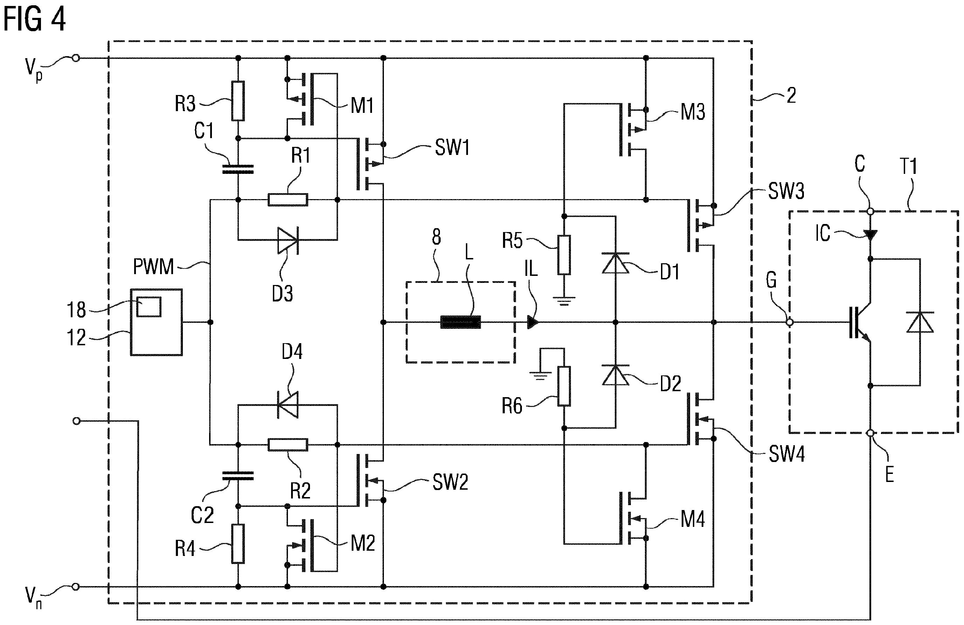

FIG 4 zeigt eine schematische Schaltbilddarstellung einer dritten Ausgestaltung einer Treiberschaltung 2, wobei die Schalter SW1, SW2, SW3 und SW4 über den Ausgang des Pulsweitenmodulators 12 ein pulsweitenmoduliertes Signal PWM erhalten. Die Schalter SW1 und SW3 sind als pMOS-Transistoren ausgeführt, während die Schalter SW2 und SW4 als nMOS-Transistoren ausgeführt sind. Darüber hinaus weist die Treiberschaltung 2 weitere pMOS-Transistoren M1, M3 und nMOS-Transistoren M2, M4 auf. Ein Kondensator C1 und ein Widerstand R1 verbinden das Signal PWM mit den Schaltern SW1 und SW3 und sorgen gleichzeitig für eine Entkopplung des Signales PWM, wenn die MOSFETs M1 beziehungsweise M3 schalten. Die MOSFETs M1 und M3 dienen zur zustandsabhängigen Abschaltung der Schalter SW1 bzw. SW3. Der MOSFET M3 schaltet sich über einen Widerstand R5 ein und über eine Diode D1 ab. Der Widerstand R3 sorgt in Kombination mit Kondensator C1 für eine endliche Einschaltzeit des Schalters SW1, sollte beispielsweise der Halbleiterschalter T1 aufgrund eines Gate-Emitter-Kurzschlusses nicht einzuschalten sein. Diese Einschaltzeit ist über die RC-Kombination so zu wählen, so dass im regulären Betrieb ein genügend zeitlicher Abstand zur regulären Einschaltzeit ist. Die Diode D3 beschleunigt den Ausschaltvorgang des Schalters SW3 beim Wechsel des Signales PWM vom Emitterpotential E zum Einschaltpotential Vp. Die komplementär angebrachte Schaltung mit den Schaltern SW2 und SW4 übernimmt die entsprechende Funktion für den Ausschaltvorgang.

Bei ausgeschaltetem Halbleiterschalter T1 führt das Signal PWM das Einschaltpotential Vp und bestimmt die Gate-Spannung des ersten Schalters SW1, der folglich ausgeschaltet ist. Am Widerstand R3 und am Kondensator C1 fällt keine Spannung ab. Der dritte Schalter SW3 ist aufgrund dessen Gate-Spannung, die dem Signal PWM entspricht, auch ausgeschaltet. Der MOSFET M3 ist in diesem Zustand eingeschaltet, da dessen Gate-Spannung über Widerstand R5 das Emitterpotential E annimmt und die Gate-Spannung des Halbleiterschalters T1 das Ausschaltpotential Vn führt. Die Diode D1 sperrt in diesem Zustand.

Beim Einschalten des Halbleiterschalters T1 wechselt das Signal PWM vom Einschaltpotential Vp zum Emitterpotential E. Die Gate-Spannung des Schalters SW1 folgt dem Signal PWM und der Schalter SW1 schaltet ein. Der Kondensator C1 lädt sich über den Widerstand R3 auf. Im regulären Betrieb schaltet der MOSFET M1 den Schalter SW1 aus, bevor der Kondensator C1 sich auf einem Wert auflädt, bei dem der Schalter SW1 abschalten könnte. Der Schalter SW3 bleibt solange ausgeschaltet, da über den Widerstand R5 der MOSFET M3 eingeschaltet ist und dieser das Gate- mit dem Source-Anschluss des Schalters SW3 kurzschließt. Steigt die Gate-Spannung des Halbleiterschalters T1 auf einer Spannung, die höher als die Thresholsspannung des MOSFETs M3 und zuzüglich der Schleusenspannung der Diode D1 ist, so schaltet der MOSFET M3 ab und gibt den Schalter SW3 frei. Über den Widerstand R1 wird nun der Gate-Anschluss des Schalters SW3 auf das Emitterpotential E gelegt und der Schalters SW3 schaltet ein. Zur gleichen Zeit schaltet der MOSFET M1 ein, da dessen Gate-Anschluss mit dem gleichen Potential des Gate-Anschlusses des Schalters SW3 verbunden ist. Der MOSFET M1 schließt den Gate- mit dem Source-Anschluss des Schalters SW1 kurz, womit der Schalter SW1 abschaltet und die Induktivität L über den eingeschalteten Schalter SW3 und der Inversdiode des Schalters SW2 freilaufen kann.

Beim Ausschalten des Halbleiterschalters T1 steigt das Signal PWM vom Emitterpotential E zum Einschaltpotential Vp. Der aufgeladene Kondensator C1 entlädt sich unmittelbar über die Inversdiode des MOSFETs M1. Die Diode D3 entlädt schlagartig das Gate des Schalters SW3, indem das Signal PWM das Gate-Potential auf die Einschaltpotential Vp anhebt. Das Signal PWM verrichtet an der komplementär angebrachten Schaltung den Ausschaltvorgang für den Halbleiterschalter T1 in umgekehrter Weise wie beim Einschalten. Die weitere Ausführung der Treiberschaltung 2 in FIG 4 entspricht der Ausführung in FIG 3.

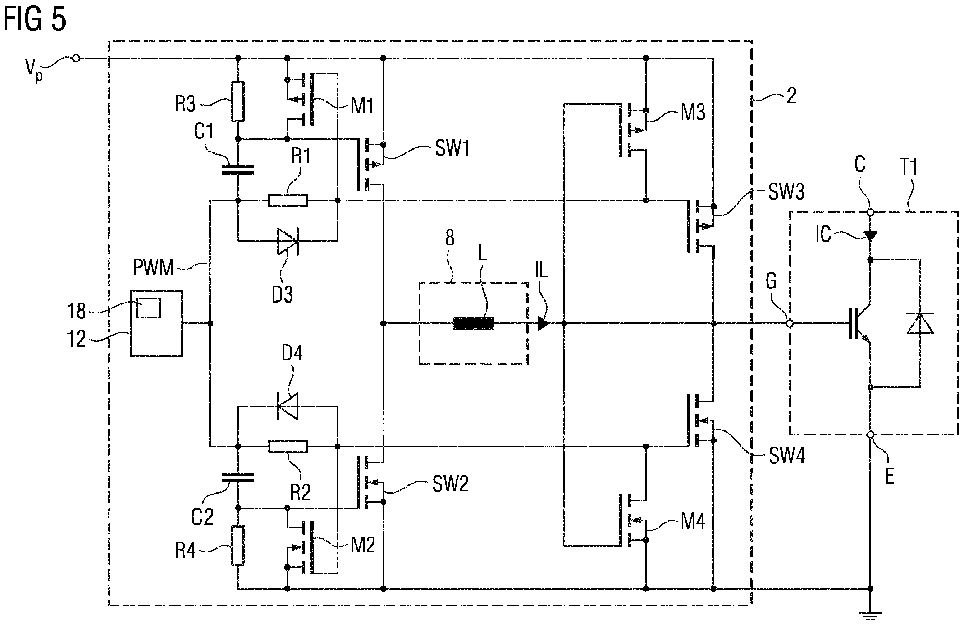

FIG 5 zeigt eine schematische Schaltbilddarstellung einer vierten Ausgestaltung einer Treiberschaltung 2, wobei die Spannungsversorgung als unipolare Spannungsversorgung ausgeführt ist. Aufgrund der geringeren Spannungsbelastung der Gates der MOSFETs, wenn diese beispielsweise mit einem Einschaltpotential Vp von 15 V gegen Masse betrieben werden, entfällt die Beschaltung der MOSFETs M3 und M4 mit den Widerständen R5 und R6 sowie den Dioden D1 und D2 verglichen mit FIG 4. Das Signal PWM ist beispielsweise mit einer einzigen Treiberstufe, welche in FIG 5 nicht dargestellt ist, und beispielsweise Teil des Pulsweitenmodulators 12 ist, generierbar. Eine derartige Treiberstufe ist beispielsweise als integrierte "Totem-Pole"- oder auch Gegentaktstufe ausgeführt. Die Schaltung in FIG 5 ist vorteilhaft, da das Gate G bei einer unipolaren Versorgung im nichtleitenden Zustand des Halbleiterschalters niederohmig auf dem Emitterpotential, insbesondere auf Masse, liegt. Die weitere Ausführung der Treiberschaltung 2 in FIG 5 entspricht der Ausführung in FIG 4.

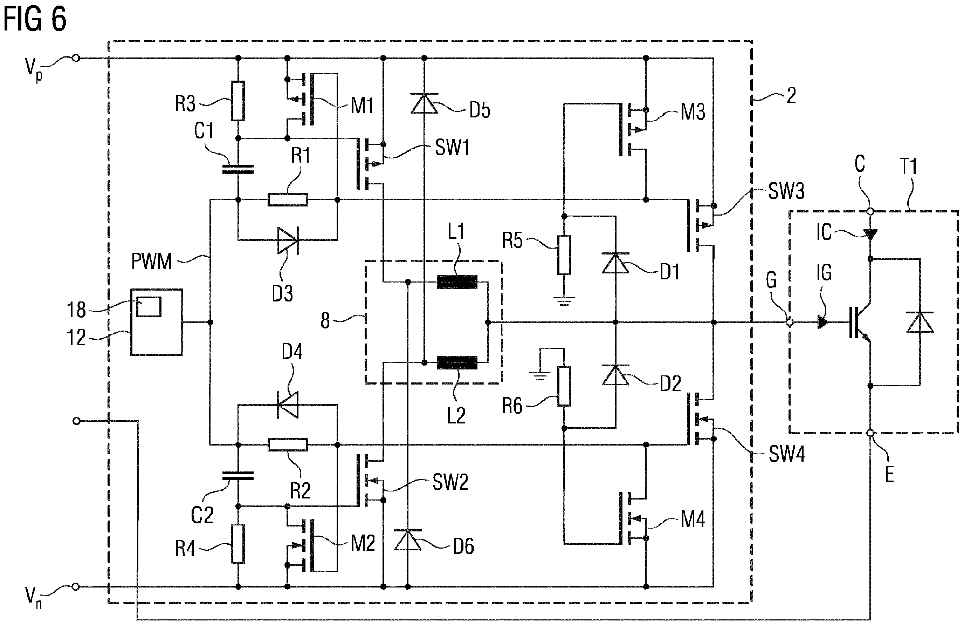

FIG 6 zeigt eine schematische Schaltbilddarstellung einer fünften Ausgestaltung einer Treiberschaltung. Die beiden Induktivitäten L1, L2 ermöglichen eine getrennte Schaltgeschwindigkeitseinstellung für das Ein- und Ausschalten des Halbleiterschalters T1. Die Diode D5 ist der Freilauf für L2 beim Ausschalten des Halbleiterschalters T1 während die Diode D6 der Freilauf für L1 beim Einschalten des Halbleiterschalters T1 ist. Die Schaltung in FIG 6 ist mit einer unipolaren Spannungsversorgung gemäß FIG 5 betreibbar. Die weitere Ausführung der Treiberschaltung 2 in FIG 6 entspricht der Ausführung in FIG 4.

Zusammenfassend betrifft die Erfindung ein Verfahren zur Ansteuerung eines, insbesondere abschaltbaren, Halbleiterschalters T1. Um eine vom Laststrom IC im Wesentlichen unabhängige Schaltgeschwindigkeit des Halbleiterschalters T1 zu erreichen, wird vorgeschlagen, dass ein Ansteuersignal von einer Treiberschaltung 2 erzeugt wird, welche ein Impedanzelement 8 mit einer Induktivität L, L1, L2 aufweist, wobei das Impedanzelement 8 einen ersten Anschluss 4 und einen zweiten Anschluss 6 aufweist, wobei der erste Anschluss 4 des Impedanzelements 8 mit einem Steueranschluss 10 des Halbleiterschalters T1 verbunden ist, wobei der zweite Anschluss 6 über einen ersten Schalter SW1 mit einem Einschaltpotential Vp und über einen zweiten Schalter SW2 mit einem Ausschaltpotential Vn verbunden ist, wobei der erste Anschluss 4 über einen dritten Schalter SW3 mit einem Einschaltpotential Vp und über einen vierten Schalter SW4 mit einem Ausschaltpotential Vn verbunden ist, wobei der Steueranschluss 10 durch einen geschlossenen vierten Schalter SW4 auf das Ausschaltpotential Vn geschaltet und der Halbleiterschalter T1 damit ausgeschaltet ist, während die übrigen Schalter SW1, SW2, SW3 geöffnet sind, wobei zum Einschalten des Halbleiterschalters T1 der Steueranschluss 10 durch gleichzeitiges Schließen des ersten Schalters SW1 und Öffnen des vierten Schalters SW4 über das Impedanzelement 8 auf das Einschaltpotential Vp geschaltet wird, sodass ein Strom IL in der Induktivität L, L1, L2 ansteigt und eine Kapazität des Halbleiterschalters T1 geladen wird, wobei, sobald eine Steuerspannung UG des Halbleiterschalters T1 das Einschaltpotential Vp erreicht, der Steueranschluss 10 durch gleichzeitiges Schließen des dritten Schalters SW3 und Öffnen des ersten Schalters SW1 direkt auf das Einschaltpotential Vp geschaltet wird.

## Patentansprüche

1. Verfahren zur Ansteuerung eines, insbesondere abschaltbaren, Halbleiterschalters (T1),
wobei ein Ansteuersignal von einer Treiberschaltung (2) erzeugt wird, welche ein Impedanzelement (8) mit einer Induktivität (L, L1, L2) aufweist,
wobei das Impedanzelement (8) einen ersten Anschluss (4) und einen zweiten Anschluss (6) aufweist,
wobei der erste Anschluss (4) des Impedanzelements (8) mit einem Steueranschluss (10) des Halbleiterschalters (T1) verbunden ist,
wobei der zweite Anschluss (6) über einen ersten Schalter (SW1) mit einem Einschaltpotential (Vp) und über einen zweiten Schalter (SW2) mit einem Ausschaltpotential (Vn) verbunden ist,
wobei der erste Anschluss (4) über einen dritten Schalter (SW3) mit einem Einschaltpotential (Vp) und über einen vierten Schalter (SW4) mit einem Ausschaltpotential (Vn) verbunden ist,
wobei der Steueranschluss (10) durch einen geschlossenen vierten Schalter (SW4) auf das Ausschaltpotential (Vn) geschaltet und der Halbleiterschalter (T1) damit ausgeschaltet ist, während die übrigen Schalter (SW1, SW2, SW3) geöffnet sind,
wobei zum Einschalten des Halbleiterschalters (T1) der Steueranschluss (10) durch gleichzeitiges Schließen des ersten Schalters (SW1) und Öffnen des vierten Schalters (SW4) über das Impedanzelement (8) auf das Einschaltpotential (Vp) geschaltet wird, sodass ein Strom (IL) in der Induktivität (L, L1, L2) ansteigt und eine Kapazität des Halbleiterschalters (T1) geladen wird,
wobei, sobald eine Steuerspannung (UG) des Halbleiterschalters (T1) das Einschaltpotential (Vp) erreicht, der Steueranschluss (10) durch gleichzeitiges Schließen des dritten Schalters (SW3) und Öffnen des ersten Schalters (SW1) direkt auf das Einschaltpotential (Vp) geschaltet wird.

2. Verfahren nach Anspruch 1,
wobei zum Ausschalten des Halbleiterschalters (T1) der Steueranschluss (10) durch gleichzeitiges Schließen des zweiten Schalters (SW2) und Öffnen des dritten Schalters (SW3) über das Impedanzelement (8) auf das Ausschaltpotential (Vn) geschaltet wird, sodass der Strom (IL) in der Induktivität (L, L1, L2) ansteigt und eine Kapazität des Halbleiterschalters (T1) geladen wird,
wobei, sobald die Steuerspannung (UG) des Halbleiterschalters (T1) das Ausschaltpotential (Vn) erreicht, der Steueranschluss (10) durch gleichzeitiges Schließen des vierten Schalters (SW4) und Öffnen des dritten Schalters (SW3) direkt auf das Ausschaltpotential (Vn) geschaltet wird.

3. Verfahren nach einem der vorherigen Ansprüche,
wobei ein erster Zeitpunkt (t1), an dem die Steuerspannung (UG) des Halbleiterschalters (T1) das Einschaltpotential (Vp) erreicht, detektiert wird und
wobei der Steueranschluss (10) anhand des detektierten ersten Zeitpunkts (t1) direkt auf das Einschaltpotential (Vp) geschaltet wird.

4. Verfahren nach einem der Ansprüche 2 oder 3,
wobei ein zweiter Zeitpunkt (t2), an dem die Steuerspannung (UG) des Halbleiterschalters (T1) das Ausschaltpotential (Vn) erreicht, detektiert wird und
wobei der Steueranschluss (10) anhand des detektierten zweiten Zeitpunkts (t2) direkt auf das Einschaltpotential (Vp) geschaltet wird.

5. Verfahren nach einem der Ansprüche 3 oder 4,
wobei der erste Zeitpunkt (t1) und/oder der zweite Zeitpunkt (t2) mit Hilfe zumindest einer Vergleichsoperation detektiert werden.

6. Verfahren nach einem der vorherigen Ansprüche,
wobei die Spannungsversorgung als unipolare Spannungsversorgung ausgeführt ist und
wobei das Ausschaltpotential (Vn) einem Bezugspotential entspricht.

7. Verfahren nach einem der vorherigen Ansprüche,
wobei zumindest zwei der Schalter (SW1, SW2, SW3, SW4) unabhängig voneinander angesteuert werden.

8. Steuereinheit (18) mit Mitteln zur Durchführung eines Verfahrens nach einem der Ansprüche 1 bis 7.

9. Computerprogramm zur Durchführung eines Verfahrens nach einem der Ansprüche 1 bis 7 bei Ablauf in einer Steuereinheit (18) nach Anspruch 8.

10. Computerprogrammprodukt mit einem Computerprogramm nach Anspruch 9.

11. Treiberschaltung (2) zur Ansteuerung eines Halbleiterschalters (T1) mit einer Steuereinheit (18) nach Anspruch 8.

12. Treiberschaltung (2) nach Anspruch 11 mit einem Impedanzelement (8), welches eine Induktivität (L, L1, L2), einen ersten Anschluss (4) und einen zweiten Anschluss (6) aufweist,
wobei der zweite Anschluss (6) über einen ersten Schalter (SW1) mit einem Einschaltpotential (Vp) und über einen zweiten Schalter (SW2) mit einem Ausschaltpotential (Vn) verbunden ist,
wobei der erste Anschluss (4) über einen dritten Schalter (SW3) mit einem Einschaltpotential (Vp) und über einen vierten Schalter (SW4) mit einem Ausschaltpotential (Vn) verbunden ist.

13. Treiberschaltung (2) nach Anspruch 12,
welche für die Ansteuerung eines IGBTs ausgelegt ist und wobei für die Schalter (SW1, SW2, SW3, SW4) MOSFETS und/oder Bipolartransistoren verwendet werden.

14. Treiberschaltung (2) nach einem der Ansprüche 11 bis 13, aufweisend Mittel zur Detektion eines Zeitpunkts (t1, t2), an dem eine Steuerspannung (UG) das Einschaltpotential (Vp) oder das Ausschaltpotential (Vn) erreicht.

15. Stromrichter mit zumindest einem, insbesondere abschaltbaren, Halbleiterschalter (T1) und einer Treiberschaltung (2) nach einem der Ansprüche 11 bis 14.
